# EUROPÄISCHE PATENTSCHRIFT

(11) **EP 0 704 060 B1**
(45) Veröffentlichungstag und Bekanntmachung des Hinweises auf die Patenterteilung: **05.03.1997**
(21) Anmeldenummer: 94917554.1
(22) Anmeldetag: 15.06.1994
(51) Int. Cl.: G01R 33/035

(54) **RF-SQUID MIT EINEM INTEGRIERTEN LAMBDA-MIKROWELLENRESONATOR ALS HOCHEMPFINDLICHES MAGNETOMETER**
RF-SQUID WITH AN INTEGRATED LAMBDA-MICROWAVE RESONATOR USEFUL AS HIGHLY SENSITIVE MAGNETOMETER
ANNEAU DE COMMUTATION DE RADIOFREQUENCES A RESONATEUR LAMBDA A HYPERFREQUENCES INTEGRE UTILE COMME MAGNETOMETRE DE HAUTE SENSIBILITE

(30) Priorität: 16.06.1993 DE 4319693
(43) Veröffentlichungstag der Anmeldung: 03.04.1996
(73) Patentinhaber: FORSCHUNGSZENTRUM JÜLICH GMBH, 52425 Jülich (DE)
(72) Erfinder: ZHANG, Yi, D-52428 Jülich (DE)
(86) Internationale Anmeldenummer: DE9400671
(87) Internationale Veröffentlichungsnummer: WO9429739

(56) Entgegenhaltungen:
- EP-A- 0 418 848
- US-A- 3 758 854
- RADIO ENGINEERING AND ELECTRONIC PHYSICS, Bd.25, Nr.12, 1980, WASHINGTON US Seiten 122 - 127 V.K.KORNEV 'Microwave frequency SQUID with a high-Q dielectric resonator'
- APPLIED PHYSICS LETTERS, Bd.60, Nr.18, 4. Mai 1992, NEW YORK US Seiten 2303 - 2305, XP275871 Y.ZHANG EA 'Microwave rf SQUID integrated into a planar YBa2Cu3O7 resonator' in der Anmeldung erwähnt
- IBM TECHNICAL DISCLOSURE BULLETIN., Bd.32, Nr.12, Mai 1990, NEW YORK US Seiten 93 - 94 'High magnetic field resolution RF squid'

## Beschreibung

Die Erfindung bezieht sich auf einen Rf-SQUID (Radio frequency-Superconducting Quantum Interference Device), bestehend aus einem supraleitenden, ein Josephson-Element aufweisenden Ring mit einem daran angekoppelten, durch einen supraleitenden Mikrowellenresonator gebildeten elektrischen Schwingkreis.

Ein SQUID ist ein Sensor zur Messung von magnetischem Fluß. Ein SQUID wird zwecks Messung eines magnetischen Feldes mit einem Flußtransformator gekoppelt, der ein magnetisches Feld in einen Fluß umwandelt. Ein konventioneller Flußtransformator besteht aus einer sogenannten Pickup-Spule zur Feld/Fluß-Umwandlung und einer Einkoppelspule zur Weiterleitung des Flusses an den SQUID. Ein solcher Aufbau wird SQUID-Magnetometer genannt.

Ein Maß für die Funktionstüchtigkeit eines SQUID-Magnetometers ist die Feldempfindlichkeit.

Zum Betrieb eines Rf-SQUID-Magnetometers wird dieser im allgemeinen an einen elektrischen Schwingkreis, auch Tankkreis genannt, angekoppelt, in welchem wiederum ein Hochfrequenzstrom mit der Resonanzfrequenz des Tankkreises eingespeist wird. Der SQUID bedämpft den Tankkreis, wobei die Größe der Bedämpfung vom magnetischen Fluß durch den supraleitenden Ring abhängig ist. Dadurch ändert sich der Spannungsabfall über dem Tankkreis, was zum Auslesen des SQUID verwendet wird.

Aus EP 04 18 848 A2 ist ein LT_{c}-RF-SQUID mit einem integrierten Mikrowellenresonator bekannt. Hier wird der supraleitende Ring sowie der Tankkreis aus einem Bauteil gebildet. Der Tankkreis besteht aus einer Streifenleitung. Die elektrische Länge der Streifenleitung entspricht der halben Wellenlänge λ der Betriebsfrequenz und bildet so einen λ/2-Mikrowellenresonator. Der Streifenresonator ist kapazitiv mit einer Auswerteelektronik verbunden.

Um die Resonatoreigenschaften sicherzustellen, ist der SQUID relativ zur Streifenleitung symmetrisch angeordnet. Des weiteren ist durch diese Symmetrie gewährleistet, daß sich der SQUID damit an einer Stelle maximalen Stromflusses befindet, wodurch eine ausreichend gute Ankopplung zwischen Resonator und SQUID sichergestellt ist.

Ein solcher Aufbau wird gemäß Appl. Phys. Lett. 60(18), p.2303, 1992 aus Hochtemperatursupraleitungsmaterialien hergestellt.

Es ist Aufgabe der Erfindung, ein Rf-SQUID-Magnetometer zu schaffen, das eine verbesserte Feldempfindlichkeit aufweist und aus Hochtemperatursupraleitungsmaterialien herstellbar ist.

Die Aufgabe wird durch ein Rf-SQUID gemäß den Merkmalen des Anspruchs 1 gelöst. Die geschlossene Leitung kann jede beliebige Geometrie aufweisen. Beispielsweise wird diese durch eine ringartige oder ovale Form realisiert. Der Aufbau ist aus einer einzigen, hochtemperatursupraleitenden Schicht herstellbar. SQUID-Ring und geschlossene Leitung sind dann aus Streifenleitungen gebildet.

Aufgrund der geschlossenen Leitung handelt es sich erstmals um einen λ- statt um einen λ/2-Resonator. Ein solcher wurde bisher insbesondere deshalb nicht eingesetzt, da es bei der dann erforderlichen geschlossenen Leitung nicht möglich ist, die vermeintlich notwendige, symmetrische Ankopplung des SQUIDs an den Resonator zu bewerkstelligen.

Die geschlossene Leitung fungiert jedoch nicht nur als Resonator sondern auch als Pickup-Spule. Im Vergleich zum Aufbau mit dem λ/2-Resonator wird dadurch die Sammlung des magnetischen Flusses erheblich gesteigert.

Für den Betrieb des SQUIDs ist in bekannter Weise mittels einer kapazitiven Ankopplung die Resonanzfrequenz einzuspeisen, die im Resonator stehende Wellen bildet. Dies kann - bei zunächst beliebiger Länge des Resonators - durch Aufsuchen bzw. Einstellen einer Resonanzfrequenz geschehen. Soll jedoch mit einer bestimmten Frequenz gearbeitet werden, so ist der Resonator so auszulegen, daß seine elektrische Länge dem einen oder mehrfachen der Wellenlänge der Betriebsfreqenz entspricht. Der SQUID ist bekanntermaßen vorteilhaft an einer Stelle maximalen Stromflusses anzuordnen.

Durch die Integration der Pickup-Spule wird die optimale Betriebsbedingung K² · Q≈1 (K: Kopplung, Q: Güte des Resonators) noch erreicht, obwohl die Kopplung zwischen Resonator und SQUID aufgrund der Asymmetrie verschlechtert wird. Insgesamt liegt eine erheblich gesteigerte Feldempfindlichkeit des SQUID-Magnetometers vor.

Vorteilhaft ist das Josephson-Element außerhalb der geschlossenen Leiterbahn angeordnet. Erreicht wird dies durch zwei Abzweigungen von der geschlossenen Leiterbahn, deren Enden so zusammengeführt sind, daß diese das Josephson-Element bilden. Die Feldempfindlichkeit wird dadurch weiter gesteigert.

Zweckmäßigerweise ist die geschlossene Leitung als Ring ausgebildet. Auf diese Weise wird die eingeschlossene Fläche und damit der gesammelte magnetische Fluß maximiert.

Vorteilhaft wird SQUID und Leiterbahn aus einer YBa₂Cu₃O_{7-X}-Schicht hergestellt.

In den Abbildungen wird der SQUID mit integriertem λ-Mikrowellenresonator schematisch dargestellt und im folgenden näher erläutert:

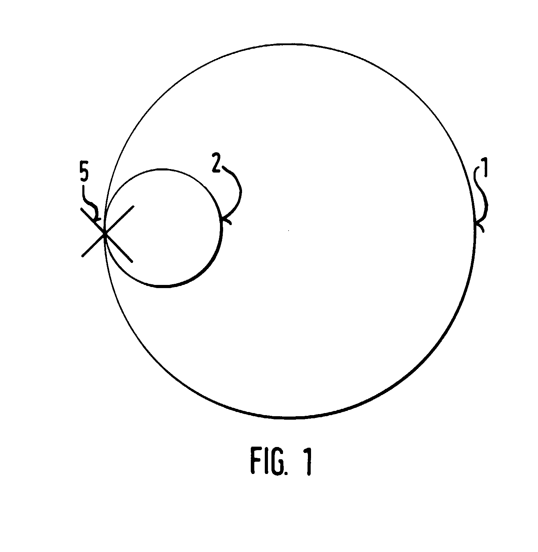

Es zeigt Fig. 1: schematische Darstellung der geschlossenen Leitung mit SQUID.
Fig. 2: aus einer Schicht hergestellte geschlossene Leitung mit angekoppeltem SQUID
Fig. 3: Ankopplung des SQUIDS an die Leitung (vergrößerte Darstellung).

In Fig. 1 ist die geschlossene Leitung 1 als Ring ausgestaltet. Hieran ist der RF-SQUID 2 angekoppelt. Das Josephson-Element 5 des SQUIDs 2 ist in die Leitung 1 integriert.

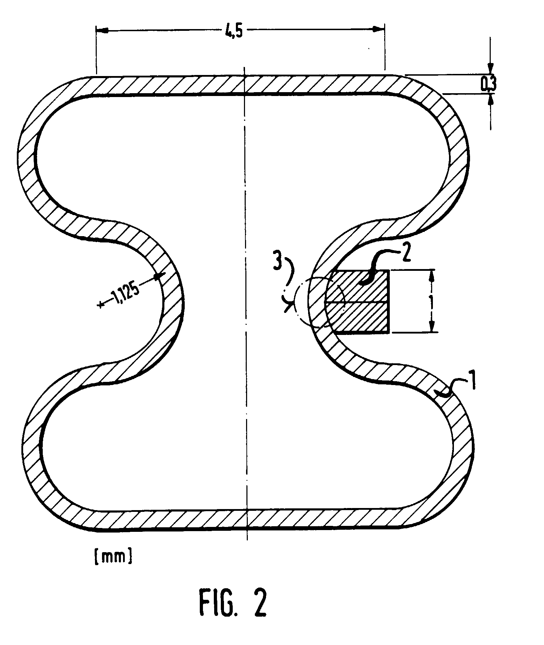

Der in Fig. 2 dargestellte SQUID mit integriertem λ-Mikrowellenresonator besteht aus einer geschlossenen Leitung, ausgebildet als Streifenleitung 1, sowie einem daran angekoppelten SQUID 2. Herstellungsbedingt weist die geschlossene Leitung 1 Einbuchtungen auf. Innerhalb einer solchen Einbuchtung befindet sich der SQUID 2.

In Fig. 2 sind Längen in mm angegeben. Der so dimensionierte Resonator weist eine Resonanzfrequenz von 3 GHz auf.

Die kapazitive Ankopplung erfolgt eine viertel Leiterbahn entfernt von der Ankoppelstelle des SQUIDs, also an einem geraden Stück der Leitung. Damit befindet sich der SQUID an einer Stelle maximalen Stromflusses.

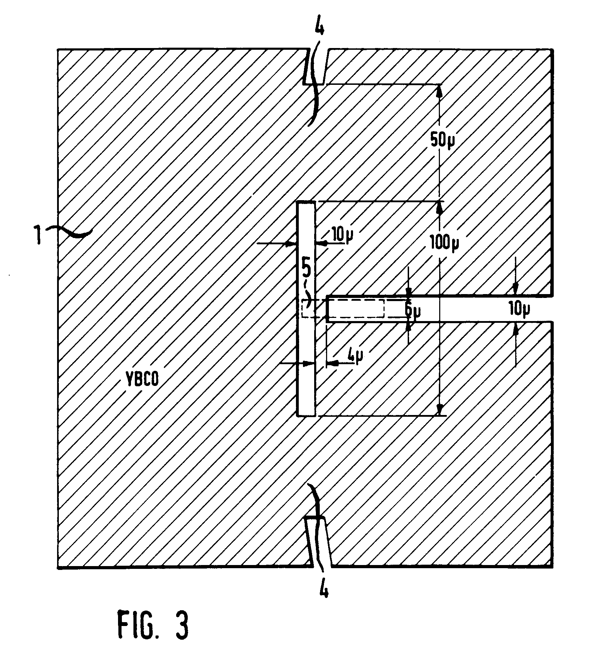

Fig. 3 stellt einen vergrößerten Ausschnitt der Ankopplungsstelle aus Fig. 2 dar. Dieser Ausschnitt ist in Fig. 2 durch einen Kreis 3 markiert.

Von der Leitung 1 zweigen zwei Leitungen 4 ab. Die Enden der beiden abzweigenden Leitungen 4 bilden ein Josephson-element 5. Der so entstandene, das Josephson-Element 5 aufweisende Ring stellt den SQUID 2 dar, wobei sich das Josephson-Element 5 außerhalb der Leiterbahn 1 befindet.

Es hat sich gezeigt, daß das in Figur 2 dargestellte, aus YBa₂Cu₃O_{7-X} hergestellte SQUID-Magnetometer viermal empfindlicher ist als ein optimiertes λ/2-Mikrowellen-SQUID-Magnetometer.

Durch geometrische Änderungen kann das Magnetometer verbessert und so die Feldempfindlichkeit weiter gesteigert werden.

## Patentansprüche

1. Rf-SQUID (2), bestehend aus einem supraleitenden, ein Josephson-Element (5) aufweisenden Ring mit einem daran angekoppelten, durch einen supraleitenden Mikrowellenresonator gebildeten elektrischen Schwingkreis
**dadurch gekennzeichnet**,
daß der Mikrowellenresonator als geschlossene, supraleitende Leitung (1) ausgebildet ist.

2. Rf-SQUID nach Anspruch 1,
**dadurch gekennzeichnet**,
daß das Josephson-Element (5) außerhalb der geschlossenen Leitung (1) angeordnet ist.

3. Rf-SQUID nach Anspruch 1 oder 2,
**dadurch gekennzeichnet,**
daß die geschlossene Leitung (1) als Ring ausgestaltet ist.

4. Rf-SQUID nach Anspruch 1, 2 oder 3,
**dadurch gekennzeichnet,**
daß SQUID (2) und Leitung (1) aus einer YBa₂Cu₃O_{7-X}-Schicht hergestellt sind.

## Claims

1. RF SQUID (2), consisting of a superconducting ring which has a Josephson junction (5) and has coupled to it a tuned electrical circuit formed by a superconducting microwave resonator, characterized in that the microwave resonator is designed as a superconducting loop (1).

2. RF SQUID according to Claim 1, characterized in that the Josephson junction (5) is arranged outside the loop (1).

3. RF SQUID according to Claim 1 or 2, characterized in that the loop (1) is configured as a ring.

4. RF SQUID according to Claim 1, 2 or 3, characterized in that the SQUID (2) and loop (1) are made from a YBa₂Cu₃O_{7-X} layer.

## Revendications

1. Dispositif SQUID à haute fréquence (2), constitué par un anneau supraconducteur comportant un élément de Josephson (5) possédant un circuit oscillant électrique, qui est accouplé à cet élément et formé par un résonateur supraconducteur à micro-ondes, caractérisé en ce que le résonateur à micro-ondes est agencé sous la forme d'une ligne supraconductrice fermée (1).

2. Dispositif SQUID à haute fréquence selon la revendication 1, caractérisé en ce que l'élément de Josephson (5) est disposé à l'extérieur de la ligne fermée (1).

3. Dispositif SQUID à haute fréquence selon la revendication 1 ou 2, caractérisé en ce que la ligne fermée (1) est agencée sous la forme d'un anneau.

4. Dispositif SQUID à haute fréquence selon la revendication 1, 2 ou 3, caractérisé en ce que le dispositif SQUID (2) de la ligne (1) est formé par une couche de YBa₂Cu₃O₇₋ₓ.
